# EUROPEAN PATENT SPECIFICATION

(11) **EP 2 752 473 B1**
(45) Date of publication and mention of the grant of the patent: **16.10.2019**
(21) Application number: 12827340.6
(22) Date of filing: 25.07.2012
(51) Int. Cl.: H02S 40/34, H01L 31/02

(54) **JOINING MEMBER HAVING VENTILATION FUNCTION AND JOINING STRUCTURE USING SAME**
VERBINDUNGSELEMENT MIT ENTLÜFTUNGSFUNKTION UND VERBINDUNGSSTRUKTUR DAMIT
ÉLÉMENT D'ASSEMBLAGE AYANT UNE FONCTION DE VENTILATION ET STRUCTURE D'ASSEMBLAGE L'UTILISANT

(30) Priority: 02.09.2011 JP 2011191895
(43) Date of publication of application: 09.07.2014
(73) Proprietor: Nitto Denko Corporation, Osaka 567-8680 (JP)
(72) Inventor: FURUUCHI, Kouji, Ibaraki-shi Osaka 567-8680 (JP); TEZUKA, Teppei, Ibaraki-shi Osaka 567-8680 (JP); KUKI, Nobuharu, Ibaraki-shi Osaka 567-8680 (JP)
(74) Representative: Intès, Didier Gérard André
(86) International application number: PCT/JP2012/004751
(87) International publication number: WO 2013/031085

(56) References cited:
- DE-U1-202007 006 007
- DE-U1-202008 006 117
- DE-U1-212010 000 007
- JP-A- 2002 240 178
- JP-A- 2005 070 542

## Description

### TECHNICAL FIELD

The present invention relates to a joining member having a ventilation function and a joining structure including the joining member.

### BACKGROUND ART

A housing that requires ventilation is provided with a vent hole for ensuring communication between the inside and outside of the housing for ventilation. In order to prevent foreign substances such as water and dust from entering the housing through the vent hole, a ventilation member is attached to the vent hole.
In order to attach the ventilation member to the housing, a double-sided adhesive tape or an adhesive is commonly used (see Patent Literature 1). In the case where the housing is made of a thermoplastic resin, the ventilation member can also be welded to the vent hole of the housing.

In order to fix the above-mentioned housing to a support body, a joining member is used in addition to the above-mentioned ventilation member. Examples of this joining member include double-sided adhesive tapes, adhesives, and screws.

### CITATION LIST

### Patent Literature

Patent Literature 1: JP 2005-070542 A or document DE 21 2010 000 007 U1

### SUMMARY OF INVENTION

### Technical Problem

For a conventional configuration, it is necessary to prepare a ventilation member and a joining member separately.

It is an object of the present invention to provide a member having both the function of a ventilation member and the function of a joining member.

### Solution to Problem

The present invention provides a sheet-like joining member according to claim 1 having a ventilation function and used to fix a housing having a vent hole to a support body. The joining member includes: an air-permeable membrane having a first principal surface and a second principal surface; a first adhesive layer provided on a side of the first principal surface of the air-permeable membrane, the first adhesive layer being adapted to be brought into contact with the housing around the vent hole; an opening formed in the first adhesive layer so that the first principal surface of the air-permeable membrane faces the vent hole of the housing when the first adhesive layer comes into contact with the housing; a second adhesive layer provided on a side of the second principal surface of the air-permeable membrane, the second adhesive layer being adapted to be brought into contact with the support body; and a vent groove formed through the second adhesive layer or between the second adhesive layer and the air-permeable membrane so as to provide an air passage between the housing and the support body to communicate an inside of the housing and an outside of the housing when the housing is fixed to the support body using the joining member, the vent groove including a first portion extending from an outer peripheral edge of the joining member to a region corresponding to the opening and a second portion to which the second principal surface of the air-permeable membrane is exposed in the region corresponding to the opening, wherein the vent groove is formed between the support body and the air-permeable membrane and communicates with the exterior space of the housing when the housing is fixed to the support body using the joining member.

The present invention also provides a joining structure including: a support body; a housing having a vent hole and fixed to the support body; and the above-mentioned joining member disposed between the support body and the housing so as to fix the housing to the support body.

### Advantageous Effects of Invention

In the joining member of the present invention, the first adhesive layer is provided on the first principal surface side, and the second adhesive layer is provided on the second principal surface side. The air-permeable membrane is disposed between the first adhesive layer and the second adhesive layer. The first adhesive layer and the second adhesive layer serve to fix the housing to the support body with the air-permeable membrane placed between the housing and the support body. The first adhesive layer adapted to be brought into contact with the housing has an opening formed therein. The vent groove is formed through the second adhesive layer or between the second adhesive layer and the air-permeable membrane so as to provide an air passage between the housing and the support body to communicate the inside of the housing and the outside of the housing. The opening and the vent groove serve to ventilate the housing through the air-permeable membrane.

As described above, the joining member of the present invention has both the joining function and the ventilation function. Therefore, the number of component parts required to produce the joining structure including the housing and the support body can be reduced. The number of man-hours required in the process for producing the joining structure can also be reduced.

### BRIEF DESCRIPTION OF DRAWINGS

FIG. 1A is a perspective view of a joining structure according to an embodiment of the present invention.
FIG. 1B is a cross-sectional view of the joining structure shown in FIG. 1A.
FIG. 2A is an exploded perspective view of a joining member used in the ventilation structure shown in FIG. 1A.
FIG. 2B is a cross-sectional view of the joining member.
FIG. 3 is a plan view of a first adhesive layer.
FIG. 4 is a plan view of a second adhesive layer.
FIG. 5 is a diagram for explaining the ventilation function of the joining member.
FIG. 6A is an exploded perspective view of a joining member according to a first modification.
FIG. 6B is a cross-sectional view of the joining member according to the first modification.
FIG. 7A is an exploded perspective view of a joining member according to a second modification.
FIG. 7B is a cross-sectional view of the joining member according to the second modification.

### DESCRIPTION OF EMBODIMENTS

Hereinafter, embodiments of the present invention will be described with reference to the accompanying drawings.

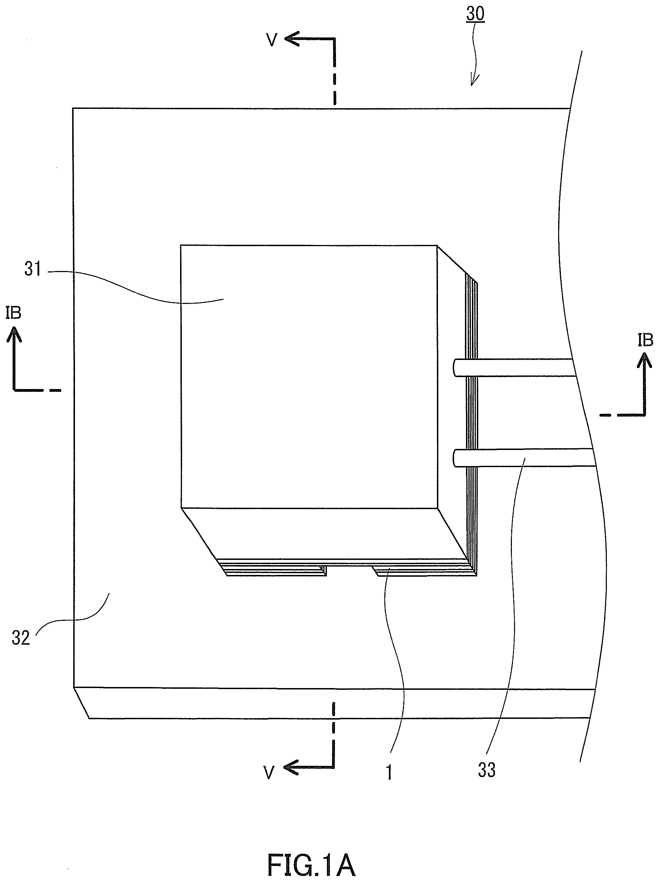

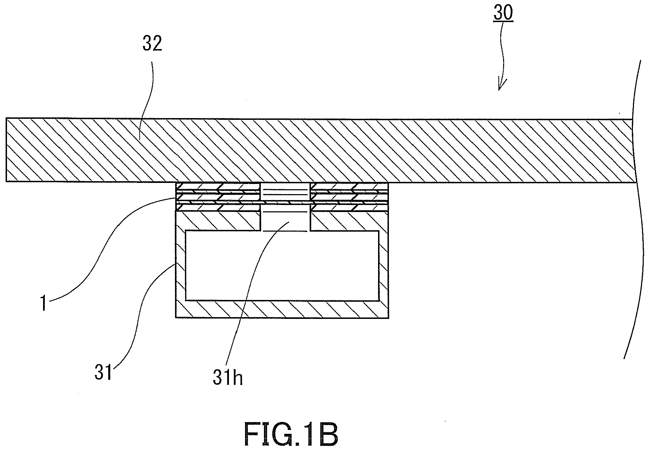

FIG. 1A is a perspective view of a joining structure according to the present embodiment. FIG. 1B is a cross-sectional view taken along a straight line IB-IB in FIG. 1A.

As shown in FIG. 1A and FIG. 1B, a joining structure 30 includes a housing 31, a support body 32, and a joining member 1. The housing 31 has a vent hole 31h. The joining member 1 is a sheet-like member and has a ventilation function. The joining member 1 is disposed between the housing 31 and the support body 32 and fixes the housing 31 to the support body 32.

FIG. 1A and FIG. 1B show the case where the support body 32 is a solar cell panel and the housing 31 is a terminal box of a solar cell. In FIG. 1A, cables 33 extend from the housing 31.

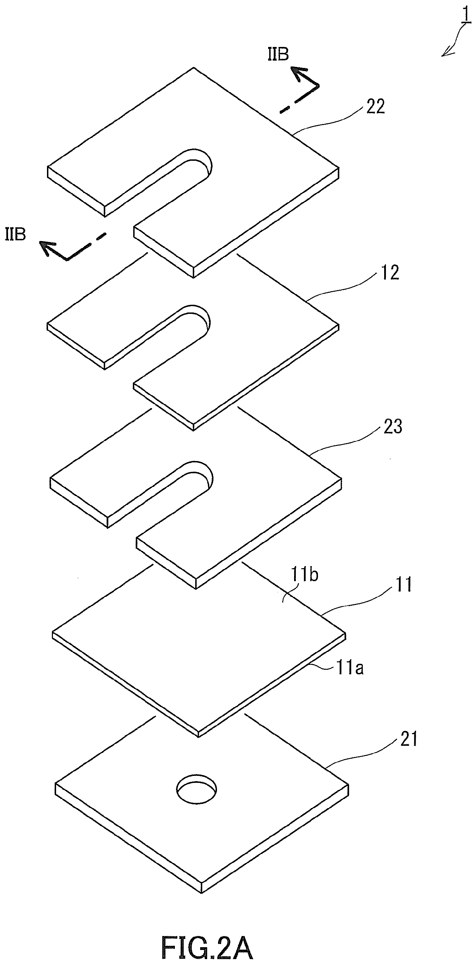

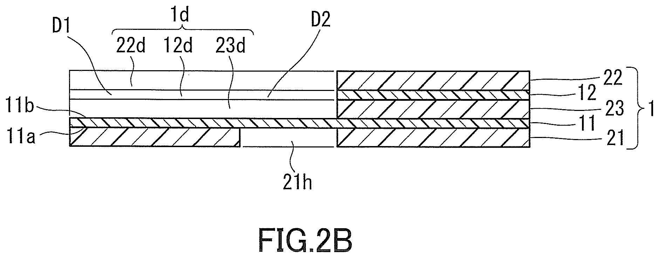

As shown in FIG. 2A and FIG. 2B, the joining member 1 includes a first adhesive layer 21, a second adhesive layer 22, a third adhesive layer 23, an air-permeable membrane 11, and a spacer 12. The first adhesive layer 21 is provided on the side of a first principal surface 11a of the air-permeable membrane 11. The second adhesive layer 22 is provided on the side of a second principal surface 11b (opposite to the first principal surface 11a) of the air-permeable membrane 11. The spacer 12 is provided between the second adhesive layer 22 and the air-permeable membrane 11. The third adhesive layer 23 is provided between the spacer 12 and the air-permeable membrane 11. That is, in the joining member 1, the first adhesive layer 21, the air-permeable membrane 11, the third adhesive layer 23, the spacer 12, and the second adhesive layer 22 are stacked in this order. More specifically, the first adhesive layer 21 and the air-permeable membrane 11 are in direct contact with each other, the air-permeable membrane 11 and the third adhesive layer 23 are in direct contact with each other, the third adhesive layer 23 and the spacer 12 are in direct contact with each other, and the spacer 12 and the second adhesive layer 22 are in direct contact with each other.

The air-permeable membrane 11 has the properties of preventing water and dust from entering therein and allowing air to pass therethrough. That is, the air-permeable membrane 11 provides the waterproof function, dustproof function, and ventilation function to the joining member 1.

The material of the air-permeable membrane 11 is, for example a porous material. Given that the joining member 1 is sometimes used outdoors and exposed to rain or mud, it is preferable to use, as the air-permeable membrane 11, a membrane including a porous polytetrafluoroethylene (PTFE) membrane having water resistance and stain resistance. The structure of the air-permeable membrane 11 is not particularly limited. For example, the air-permeable membrane 11 may have a net structure or a nonwoven fabric structure. The air-permeable membrane 11 is square in plan view, but it may have another shape such as a polygon other than a square, or a circle.

A porous PTFE membrane can be produced by the following method, for example. First, a liquid lubricant is added to a PTFE fine powder to preform a pasty mixture. The liquid lubricant is not particularly limited as long as it can wet the surface of the PTFE fine powder and can be removed by extraction or heating. Hydrocarbons such as liquid paraffin, naphtha, and white oil can be used as the liquid lubricant. The appropriate amount of the liquid lubricant added is about 5 to 50 parts by weight per 100 parts by weight of the PTFE fine powder. The above-mentioned preforming is performed at such a pressure that the liquid lubricant is not squeezed out. Next, the mixture obtained by the above-described preforming is formed into a sheet by paste extrusion or rolling to obtain a PTFE sheet. Next, this PTFE sheet is stretched uniaxially or biaxially. Thus, a porous PTFE membrane is obtained. Stretching conditions may be determined as appropriate. For example, the temperature for stretching is 30°C to 400°C, and the stretch ratio is 1.5 to 200 for each stretching direction. In addition, in the case where the porous PTFE membrane is not sintered in the stretching process, it is preferable to sinter the porous PTFE membrane at a temperature equal to or higher than the melting point of the porous PTFE membrane after the stretching.

The air-permeable membrane 11 may include an air-permeable membrane body that prevents water and dust from entering therein and allows air to pass therethrough and a reinforcing member for reinforcing the air-permeable membrane body. Examples of the air-permeable membrane body includes membranes made of the porous materials described above. Examples of the material of the reinforcing member include synthetic fibers made of resins such as polyolefins (e.g., polyethylene and polypropylene), polyamides, polyesters, aromatic polyamides, acrylics, and polyimides, and composite materials of these. Preferably, the reinforcing member has a structure whose permeability can be easily increased, such as a nonwoven fabric, a woven fabric, a net, or the like. The arrangement of the air-permeable membrane body and the reinforcing member is not particularly limited. For example, the reinforcing member may cover one side of the air-permeable membrane body, or the reinforcing members may cover both sides of the air-permeable membrane body. From the viewpoint of ensuring the waterproofness of the housing 31, it is preferable to arrange the air-permeable membrane body and the reinforcing member so that the air-permeable membrane body comes into direct contact with the first adhesive layer 21. In view of this point, the reinforcing member preferably covers only one side of the air-permeable membrane body.

The thickness of the air-permeable membrane 11 is, for example, 5 to 2000 µm, and preferably 10 to 500 µm.

Preferably, the air-permeable membrane 11 has a water entry pressure of 5 cm/H₂O or more for the following reasons. The internal pressure of the housing 31 is lower than the external pressure thereof in some environments of use. In such a case, even if the air-permeable membrane 11 has water resistance, water or the like outside the housing 31 may penetrate the air-permeable membrane 11 and be drawn into the housing 31. Therefore, it is preferable that the air-permeable membrane 11 have not only water resistance but also a predetermined level of water entry pressure. When the air-permeable membrane 11 has a water entry pressure in the range given above, the risk that outside water or the like may be drawn into the housing can be reduced effectively. This means that, when the air-permeable membrane 11 has a water entry pressure given above, it can have good internal pressure controllability.

The air-permeable membrane 11 may be subjected to oil-repellent treatment. For example, when the housing 31 is used to contain automotive electronic components, window washer fluid, oil such as engine oil and brake oil, etc. may adhere to the vicinity of the housing 31, which in turn adheres to the surface of the air-permeable membrane 11. Oil-repellent treatment makes it possible to more effectively prevent a low surface tension liquid from penetrating the air-permeable membrane 11.

The first adhesive layer 21 is a layer adapted to be brought into contact with the housing 31 around the vent hole 31h. The first adhesive layer 21 may be made of a single material, or may contain two or more materials. For example, the first adhesive layer 21 may consist only of an adhesive, or may be a double-sided adhesive tape including a substrate and an adhesive applied to both sides of the substrate. From the viewpoint of ease of producing the joining member 1, the first adhesive layer 21 is preferably a double-sided adhesive tape. The same applies to the second adhesive layer 22 and the third adhesive layer 23 as well. In the present embodiment, the first adhesive layer 21 is a double-sided adhesive tape. The thickness of the first adhesive layer 21 is, for example, 25 to 3000 µm.

The second adhesive layer 22 is a layer adapted to be brought into contact with the support body 32. The third adhesive layer 23 is a layer for bonding the spacer 12 to the air-permeable membrane 11. The second adhesive layer 22 and the third adhesive layer 23 can each have the same structure as the first adhesive layer 21. In the present embodiment, the second adhesive layer 22 and the third adhesive layer 23 are each a double-sided adhesive tape.

The spacer 12 is a member for maintaining a space between the air-permeable membrane 11 and the support body 32. In the present embodiment, a polyethylene terephthalate (PET) film is used as the spacer 12. Another plastic film may be used as the spacer 12.

In the joining structure 30, the joining member 1 forms an air passage communicating the inside and outside of the housing 31. In the present embodiment, the air-permeable membrane 11 is sandwiched between the first adhesive layer 21 and the second adhesive layer 22, the spacer 12 and the third adhesive layer 23, so as to form the air passage. The shapes of the first adhesive layer 21, the second adhesive layer 22, the spacer 12, and the third adhesive layer 23 for forming the air passage, and that air passage are described below.

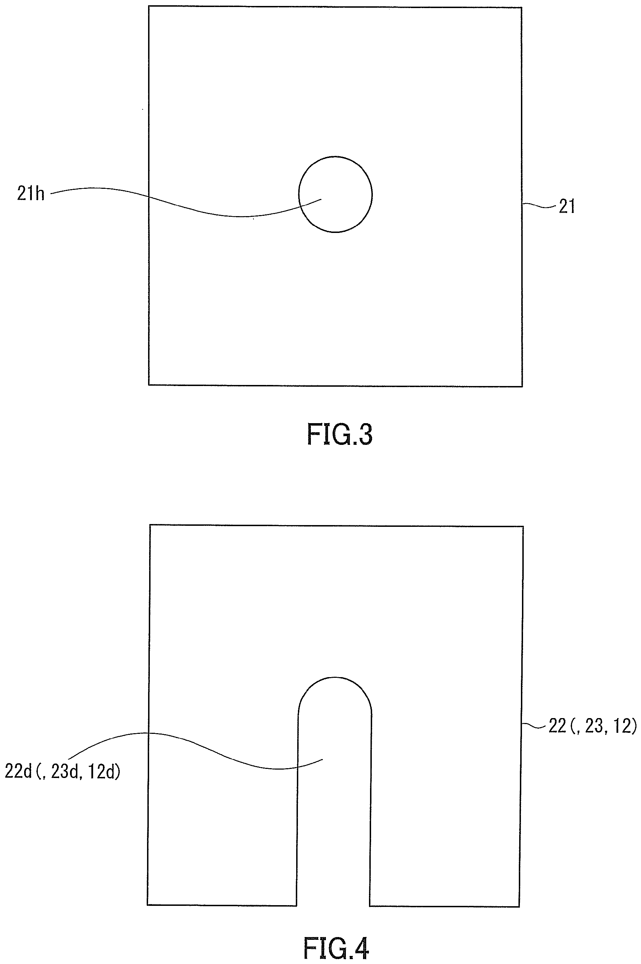

FIG. 3 is a plan view of the first adhesive layer 21. As shown in FIG. 3, the first adhesive layer 21 has an opening 21h formed therein. The opening 21h is provided in the center of the first adhesive layer 21. In the ventilation structure 30, the opening 21h of the first adhesive layer 21 coincides with the vent hole 31h of the housing 31.

FIG. 4 is a plan view of the second adhesive layer 22. As shown in FIG. 4, the second adhesive layer 22 has a vent recess 22d formed therein.

In the present embodiment, the spacer 12 and the third adhesive layer 23 have the same shape as the second adhesive layer 22 in plan view. That is, the spacer 12 has a vent recess 12d, and the third adhesive layer 23 has a vent recess 23d. The vent recess 12d and the vent recess 23d have the same shape as the vent recess 22d in plan view.

In the joining member 1 of the present embodiment, the second adhesive layer 22, the spacer 12, and the third adhesive layer 23 are stacked so that their side edges are aligned (see FIG. 2B). Thus, the second adhesive layer 22, the spacer 12, and the third adhesive layer 23 form a vent groove 1d having a thickness corresponding to the total thickness of these three layers.

In other words, the vent groove 1d is formed through the second adhesive layer 22, the spacer 12, and the third adhesive layer 23. The vent groove 1d includes a first portion D1 and a second portion D2. The first portion D1 of the vent groove 1d is a portion extending from the outer peripheral edge of the joining member 1 to a region corresponding to the opening 21h (a region overlapping or coinciding with the opening 21h in plan view). The second portion D2 of the vent groove 1d is a portion to which the second principal surface 11b of the air-permeable membrane 11 is exposed in the region corresponding to the opening 21h. The vent groove 1d is separated from the opening 21h by the air-permeable membrane 11. As described below, when the housing 31 is fixed to the support body 32 using the joining member 1, the vent groove 1d provides an air passage between the housing 31 and the support body 32 to communicate the inside of the housing 31 and the outside of the housing 31.

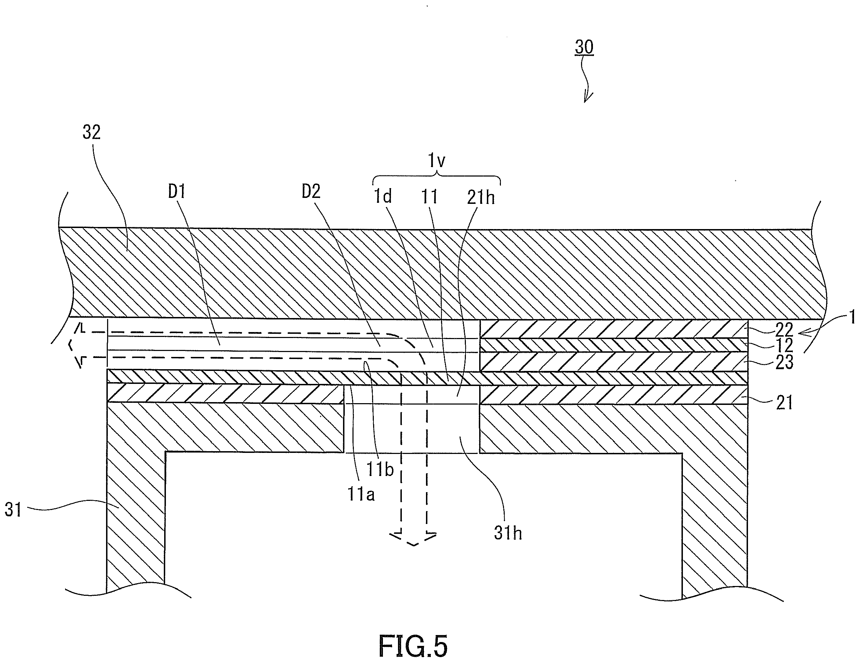

Next, the ventilation function of the joining member 1 is described with reference to FIG. 5. FIG. 5 is a cross-sectional view taken along a straight line V-V in FIG. 1A. As shown in FIG. 5, since the opening 21h is formed in the first adhesive layer 21, the first principal surface 11a of the air-permeable membrane 11 faces the vent hole 31h of the housing 31 when the first adhesive layer 21 comes into contact with the housing 31. Therefore, the interior space of the housing 31, the vent hole 31h, and the opening 21h communicate with each other. On the other hand, the vent groove 1d is formed between the support body 32 and the air-permeable membrane 11 and communicates with the exterior space of the housing 31. More specifically, a space of the vent groove 1d is formed between the support body 32 and the air-permeable membrane 11, and this space and the exterior space of the housing 31 communicate with each other. That is, in the joining structure 30, the interior space and the exterior space of the housing 31 are separated from each other only by the air-permeable membrane 11. This means that the opening 21h, the air-permeable membrane 11, and the vent groove 1d form an air passage 1v. The air passage 1v is never blocked by the support body 32. Therefore, the air passage 1v ensures communication between the interior space and the exterior space of the housing 31 for good ventilation of the housing 31.

In the present embodiment, the vent groove 1d is also formed through the spacer 12, and has a depth equal to or greater than the thickness of the spacer 12. The bottom of the vent groove 1d is formed of the second principal surface 11b of the air-permeable membrane 11. The vent groove 1d has a depth equal to the total thickness of the second adhesive layer 22, the spacer 12, and the third adhesive layer 23. As described later, the spacer 12 and the third adhesive layer 23 are not essential components. However, the presence of the spacer 12 and the third adhesive layer 23 makes the vent groove 1d deeper. That is, when the joining structure 30 is assembled, the air flow cross sectional area of the air passage 1v is increased on the side of the second principal surface 11b of the air-permeable membrane 11. As a result, good ventilation of the housing 31 can be ensured in the joining structure 30.

The dimensions of the vent groove 1d is not particularly limited, but the depth of the vent groove 1d is, for example, 50 to 5000 µm, and preferably 200 to 300 µm.

The width of the vent groove 1d is preferably 1 to 20 mm in plan view in order to achieve both the air flow cross sectional area large enough for the vent groove 1d and the strength high enough for the joining member 1.

In the present embodiment, the vent groove 1d is a recess having a combined shape of a semicircle and a rectangle in plan view. However, the shape of the vent groove 1d is not limited. For example, the vent groove 1d may be a recess having a quadrangular shape such as a rectangle in plan view. The second adhesive layer 22, the spacer 12, and the third adhesive layer 23 may each be divided into two or more regions so that the vent groove 1d has a cross shape or the like in plan view.

In the joining member 1, the vent recess 22d, the vent recess 12d, and the vent recess 23d completely coincide with each other. However, the side edges of the vent recesses 22d, 12d and 23d may be slightly misaligned with each other as long as the vent groove 1d having a depth equal to the total thickness of the second adhesive layer 22, the spacer 12, and the third adhesive layer 23 is formed.

In the ventilation structure 30 of the present embodiment, the position of the joining member 1 and the position of the housing 31 are determined so that the vent groove 1d extends in a depression angle direction. This configuration makes it possible to prevent a liquid such as water from remaining in the vent groove 1d, resulting in a decrease in the possibility that the liquid may enter the housing 31 from the outside. However, the direction in which the vent groove 1d opens is not limited, and the vent groove 1d may extend in an elevation angle direction.

The diameter of the opening 21h formed in the first adhesive layer 21 is not particularly limited, and it is 2 to 50 mm, for example. In the present embodiment, the opening 21h has a circular shape, but it may have another shape, for example, a quadrangular shape.

The positional relationship between the vent hole 31h and the opening 21h is not particularly limited, but preferably the centers thereof coincide with each other. Thereby, good ventilation of the housing 31 can be ensured. In the present embodiment, the vent hole 31h has the same shape as the opening 21h, but they need not necessarily have the same shape. Their shapes may be slightly different from each other.

### (First Modification)

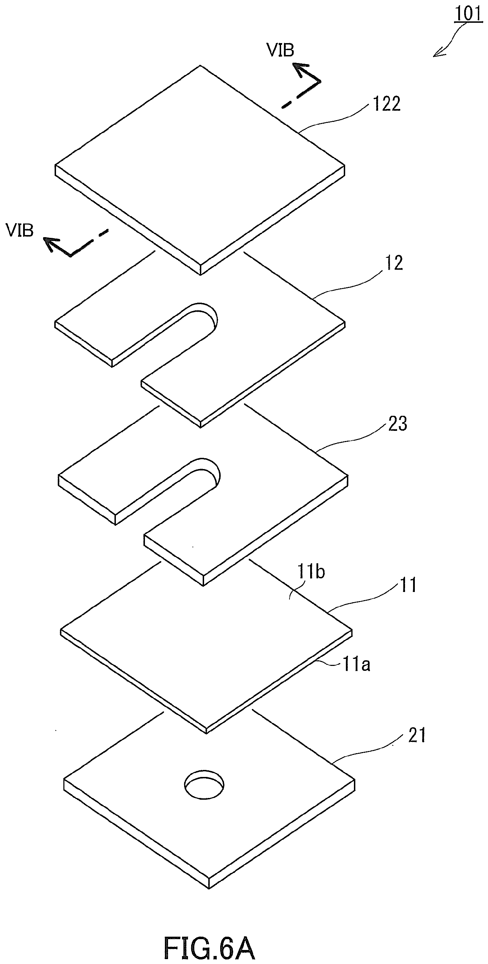

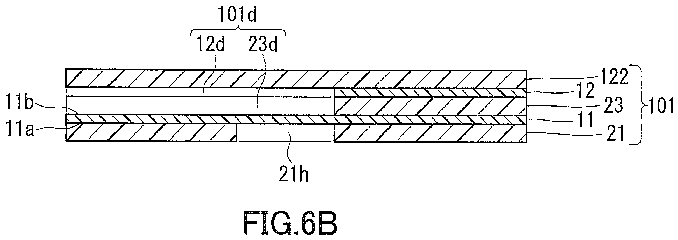

A joining member 101 shown in FIG. 6A and FIG. 6B has a second adhesive layer 122 instead of the second adhesive layer 22 of the joining member 1 in the embodiment described above. That is, in the joining member 101, the first adhesive layer 21, the air-permeable membrane 11, the third adhesive layer 23, the spacer 12, and the second adhesive layer 122 are stacked in this order. The first adhesive layer 21 and the air-permeable membrane 11 are in direct contact with each other, the air-permeable membrane 11 and the third adhesive layer 23 are in direct contact with each other, the third adhesive layer 23 and the spacer 12 are in direct contact with each other, and the spacer 12 and the second adhesive layer 122 are in direct contact with each other. The second adhesive layer 122 does not have a vent recess like the vent recess 22d. That is, the second adhesive layer 122 has the same shape as the air-permeable membrane 11 in plan view. The second adhesive layer 122 is an adhesive layer having the same structure as the second adhesive layer 22 except for this point. In the first modification using this configuration, a vent groove 101d is formed through the spacer 12 and the third adhesive layer 23 located between the second adhesive layer 122 and the air-permeable membrane 11. The vent groove 101d is covered by the second adhesive layer 122 in the thickness direction of the second adhesive layer 122.

In a joining structure (not shown) including the joining member 101, the bonding area between the joining member 101 and the support body 32 (i.e., the contact area between the second adhesive layer 122 and the support body 32) can be made larger than the bonding area between the joining member 1 and the support body 32 (i.e., the contact area between the second adhesive layer 22 and the support body 32). Therefore, the housing 31 can be fixed to the support body 32 more firmly when the joining member 101 is used than when the joining member 1 is used.

In the first modification, the second adhesive layer 122 does not serve as an air passage. Therefore, in the first modification, the total thickness of the spacer 12 and the third adhesive layer 23 is preferably greater than that in the embodiment described above. That is, it is preferable that the total depth of the vent recess 12d and the vent recess 23d be greater than that in the embodiment described above. For this reason, in the first modification, the total thickness of the spacer 12 and the third adhesive layer 23 is preferably 200 to 300 µm.

### (Second Modification)

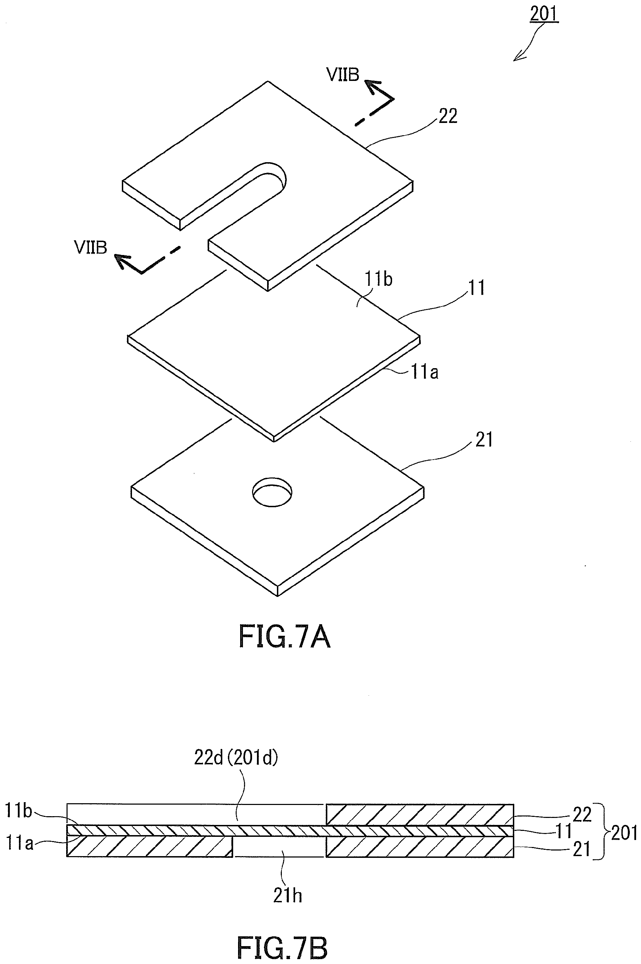

A joining member 201 shown in FIG. 7A and FIG. 7B does not have the spacer 12 and the third adhesive layer 23 of the joining member 1 in the embodiment described above. That is, in the joining member 201, the first adhesive layer 21, the air-permeable membrane 11, and the second adhesive layer 22 are stacked in this order. The first adhesive layer 21 and the air-permeable membrane 11 are in direct contact with each other, and the air-permeable membrane 11 and the second adhesive layer 22 are in direct contact with each other. In the second modification, a vent groove 201d is formed through the second adhesive layer so that the vent groove 201d has a depth equal to the thickness of the second adhesive layer 22, and the bottom of the vent groove 201d is formed of the second principal surface 11b of the air-permeable membrane 11. That is, in the second modification, the vent groove 201d is a vent recess 22d formed in the second adhesive layer 22.

The configuration of the joining member 201 is simpler than that of the joining member 1. Therefore, the joining member 201 is superior to the joining member 1 in terms of the material costs and ease of production.

However, the joining member 201 does not have layers corresponding to the spacer 12 and the third adhesive layer 23 in the embodiment described above. That is, the joining member 201 does not have the vent recess 12d and the vent recess 23d. Therefore, in the second modification, it is preferable that the thickness of the second adhesive layer 22 be greater than that in the embodiment described above. That is, the depth of the vent recess 22d is preferably greater than that in the embodiment described above. For this reason, in the second modification, the thickness of the second adhesive layer 22 is preferably 200 to 300 µm.

### EXAMPLES

Hereinafter, the present invention will be described more specifically by way of an actually produced joining member. The present invention is not limited to these examples.

### (Preparation of Component Parts)

First, component parts of the joining member were prepared.

A porous PTFE membrane was produced in the following manner. First, a pasty mixture obtained by adding 19 parts by weight of a liquid lubricant (normal decane) per 100 parts by weight of PTFE fine powder (trade name F104, manufactured by Daikin Industries, Ltd.) was preformed, and the resulting preformed body was formed into a round bar form by paste extrusion to obtain a formed body. Next, the formed body was rolled into a sheet with a thickness of 0.2 mm. After the rolling, the liquid lubricant was removed from the sheet in a drying furnace at 150°C. Next, the sheet was stretched in the longitudinal direction at a stretch ratio of 2 at 280°C, and further stretched at a stretch ratio of 4 at a temperature of 360°C. After the stretching in the longitudinal direction, the sheet was stretched in the transverse direction at a stretch ratio of 5 in a 100°C atmosphere. Thus, a porous PTFE membrane was obtained. The thickness of the porous PTFE membrane thus obtained was 80 µm.

A double-sided tape (No. 5620A, manufactured by Nitto Denko Corporation) was prepared for use as a first adhesive layer, a second adhesive layer, and a third adhesive layer. The thickness of this double-sided take was 200 µm.

As a spacer, a PET film (Lumirror S10 (#100) manufactured by Toray Industries, Inc.) was prepared. The thickness of this PET film was 100 nm.

### (Shaping of Component Parts)

Next, the component parts thus prepared were subjected to shaping to adjust the dimensions and shapes thereof. Specifically, each of the component parts was subjected to punching using a Thomson die cutter.

First, the porous PTFE membrane was punched into a square of 50 mm × 50 mm in plan view.

Next, the both-sided adhesive tape for the first adhesive layer was punched into a shape as shown in FIG. 3. Specifically, the both-sided adhesive tape was punched out so that the resulting first adhesive layer had a square outline of 50 mm × 50 mm in plan view and had a 10-mm-diameter circular hole formed in the center of the layer.

Next, the both-sided adhesive tape for the second adhesive layer was punched into a shape as shown in FIG. 4. Specifically, the both-sided adhesive tape was punched out so that the resulting second adhesive layer had unrecessed three sides of 50 mm and one recessed side and that the recess included a 10-mm-diameter circular region formed in the center of the layer (i.e., a region coinciding with the hole of the first adhesive layer when the joining member was assembled) in plan view. Next, the both-sided adhesive layer for the third adhesive layer was punched in the same manner as in the formation of the second adhesive layer. Next, the PET film was punched in the same manner as in the formation of the second adhesive layer.

### (Stacking of Component Parts)

The materials obtained by punching as described above were stacked as shown in FIG. 2B. Thus, the joining member was produced. The thickness of the joining member was 780 µm.

### [Evaluation of Ventilation Performance]

The ventilation performance of the joining member thus produced was evaluated in the following manner.

First, an aluminum plate and an aluminum box having a circular vent hole with a diameter of 8 mm and a suction port to which a pump could be connected were prepared. Next, the joining member was placed between the aluminum plate and the aluminum box so as to fix the aluminum box to the aluminum plate. Specifically, the aluminum box and the first adhesive layer of the joining member were brought into contact with each other so that the center of the vent hole of the aluminum box coincided with the center of the hole of the first adhesive layer, and the aluminum plate and the third adhesive layer of the joining member were brought into contact with each other. Thus, the aluminum box was fixed to the aluminum plate. The pump was attached to the suction port of the aluminum box to suck the air out of the aluminum box. The difference between the pressure inside the aluminum box and the pressure outside the aluminum box, and the rate of air flow were measured. The pressure difference was 0.125 kPa, and the rate of air flow was 0.16 cm³/cm²/sec. The measurement results revealed that the produced joining member had good ventilation function.

### INDUSTRIAL APPLICABILITY

The joining member of the present invention can be used to fix a terminal box of a solar cell that requires ventilation to a solar cell panel. However, the use of the joining member of the present invention is not limited. For example, the joining member of the present invention can be used to mount an ECU box to a support body such as a car body.

## Claims

1. A sheet-like joining member having a ventilation function and used to fix a housing (31) having a vent hole (31h) to a support body (32), the joining member comprising:
an air-permeable membrane (11) having a first principal surface and a second principal surface;
a first adhesive layer (21) provided on a side of the first principal surface of the air-permeable membrane, the first adhesive layer being adapted to be brought into contact with the housing (31) around the vent hole (31h);
an opening (21h) formed in the first adhesive layer so that the first principal surface of the air-permeable membrane faces the vent hole of the housing when the first adhesive layer comes into contact with the housing;
a second adhesive layer (21, 122) provided on a side of the second principal surface of the air-permeable membrane, the second adhesive layer being adapted to be brought into contact with the support body; and
a vent groove (1d, 101d, 201d) formed through the second adhesive layer (22, 122) or between the second adhesive layer and the air-permeable membrane (11) so as to provide an air passage between the housing (31) and the support body (32) to communicate an inside of the housing and an outside of the housing when the housing is fixed to the support body using the joining member, the vent groove including a first portion (D1) extending from an outer peripheral edge of the joining member to a region corresponding to the opening (21h) and a second portion (D2) to which the second principal surface of the air-permeable membrane (11) is exposed in the region corresponding to the opening (21h),
wherein the vent groove (1d, 101d, 201d) is formed between the support body (32) and the air-permeable membrane (11) and communicates with the exterior space of the housing (31) when the housing is fixed to the support body using the joining member.

2. The joining member according to claim 1, further comprising:
a spacer (12) provided between the second adhesive layer (22, 122) and the air-permeable membrane (11); and
a third adhesive layer (23) provided between the spacer (12) and the air-permeable membrane (11),
wherein the vent groove (1d, 101d) is formed at least through the spacer (12) so that the vent groove has a depth equal to or greater than a thickness of the spacer.

3. The joining member according to claim 2, wherein
the vent groove (1d) is formed through the second adhesive layer (22), the spacer (12), and the third adhesive layer so that the vent groove has a depth equal to a total thickness of the second adhesive layer (23), the spacer, and the third adhesive layer, and
the vent groove (1d) has a bottom formed of the second principal surface of the air-permeable membrane (11).

4. The joining member according to claim 1, wherein
the vent groove (201d) is formed through the second adhesive layer (22) so that the vent groove has a depth equal to a thickness of the second adhesive layer, and
the vent groove (201d) has a bottom formed of the second principal surface of the air-permeable membrane (11).

5. The joining member according to claim 1, wherein the air-permeable membrane (11) comprises a porous polytetrafluoroethylene membrane.

6. The joining member according to claim 1, wherein the first adhesive layer (21) and the second adhesive layer (22, 122) are each formed of a double-sided adhesive tape.

7. A joining structure comprising:
a support body (32);
a housing (31) having a vent hole (31h) and fixed to the support body; and
a sheet-like joining member (1, 101, 201) according to any one of claims 1 to 6, disposed between the support body and the housing so as to fix the housing to the support body,
wherein the first adhesive layer (21) is in contact with the housing around the vent hole;
the first principal surface of the air-permeable membrane (11) faces the vent hole (31h) of the housing;
the second adhesive layer (22) is in contact with the support body; and
the vent groove (1d, 101d, 201d) is formed between the support body (32) and the air-permeable membrane (11) and communicates with the exterior space of the housing (31)

8. The joining structure according to claim 7, wherein
the support body (32) is a solar cell panel, and
the housing (31) is a terminal box of a solar cell.

## Patentansprüche

1. Plattenförmiges Verbindungselement, das eine Entlüftungsfunktion aufweist und dazu verwendet wird, ein Gehäuse (31), das ein Lüftungsloch (31h) aufweist, an einem Tragkörper (32) zu befestigen, wobei das Verbindungselement umfasst:
eine luftdurchlässige Membran (11), die eine erste Hauptfläche und eine zweite Hauptfläche aufweist,
eine erste Klebeschicht (21), die auf einer Seite der ersten Hauptfläche der luftdurchlässigen Membran vorgesehen ist, wobei die erste Klebeschicht dazu geeignet ist, mit dem Gehäuse (31) um das Lüftungsloch (31h) in Kontakt gebracht zu werden,
eine Öffnung (21h), die in der ersten Klebeschicht ausgebildet ist, sodass die erste Hauptfläche der luftdurchlässigen Membran dem Lüftungsloch des Gehäuses zugewandt ist, wenn die erste Klebeschicht mit dem Gehäuse in Kontakt kommt,
eine zweite Klebeschicht (21, 122), die auf einer Seite der zweiten Hauptfläche der luftdurchlässigen Membran vorgesehen ist, wobei die zweite Klebeschicht dazu geeignet ist, mit dem Tragkörper in Kontakt gebracht zu werden, und
eine Lüftungsnut (1d, 101 d, 201d), welche durch die zweite Klebeschicht (22, 122) oder zwischen der zweiten Klebeschicht und der luftdurchlässigen Membran (11) ausgebildet ist, um so einen Luftdurchlass zwischen dem Gehäuse (31) und dem Tragkörper (32) vorzusehen, um eine Innenseite des Gehäuses und eine Außenseite des Gehäuses miteinander zu verbinden, wenn das Gehäuse an dem Tragkörper unter Verwendung des Verbindungselements befestigt ist, wobei die Lüftungsnut einen ersten Abschnitt (D1), der sich von einer äußeren Umfangskante des Verbindungselements zu einem Bereich, welcher der Öffnung (21h) entspricht, erstreckt, und einen zweiten Abschnitt (D2) beinhaltet, zu welchem die zweite Hauptfläche der luftdurchlässigen Membran (11) in dem Bereich, welcher der Öffnung (21h) entspricht, frei liegt,
wobei die Lüftungsnut (1d, 101d, 201d) zwischen dem Tragkörper (32) und der luftdurchlässigen Membran (11) ausgebildet ist und mit dem äußeren Raum des Gehäuses (31) verbunden ist, wenn das Gehäuse an dem Tragkörper unter Verwendung des Verbindungselements befestigt ist.

2. Verbindungselement nach Anspruch 1, ferner umfassend:
einen Abstandshalter (12), der zwischen der zweiten Klebeschicht (22, 122) und der luftdurchlässigen Membran (11) vorgesehen ist, und
eine dritte Klebeschicht (23), die zwischen dem Abstandshalter (12) und der luftdurchlässigen Membran (11) vorgesehen ist,
wobei die Lüftungsnut (1d, 101d) mindestens durch den Abstandshalter (12) ausgebildet ist, sodass die Lüftungsnut eine Tiefe aufweist, die gleich einer oder größer als eine Dicke des Abstandshalters ist.

3. Verbindungselement nach Anspruch 2, wobei
die Lüftungsnut (1d) durch die zweite Klebeschicht (22), den Abstandshalter (12) und die dritte Klebeschicht ausgebildet ist, sodass die Lüftungsnut eine Tiefe aufweist, die gleich einer Gesamtdicke der zweiten Klebeschicht (23), des Abstandshalters und der dritten Klebeschicht ist, und
die Lüftungsnut (1d) eine Unterseite aufweist, die aus der zweiten Hauptfläche der luftdurchlässigen Membran (11) ausgebildet ist.

4. Verbindungselement nach Anspruch 1, wobei
die Lüftungsnut (201d) durch die zweite Klebeschicht (22) ausgebildet ist, sodass die Lüftungsnut eine Tiefe aufweist, die gleich einer Dicke der zweiten Klebeschicht ist, und
die Lüftungsnut (201d) eine Unterseite aufweist, die aus der zweiten Hauptfläche der luftdurchlässigen Membran (11) ausgebildet ist.

5. Verbindungselement nach Anspruch 1, wobei die luftdurchlässige Membran (11) eine poröse Polytetrafluorethylen-Membran umfasst.

6. Verbindungselement nach Anspruch 1, wobei die erste Klebeschicht (21) und die zweite Klebeschicht (22, 122) jeweils aus einem doppelseitigen Klebeband ausgebildet sind.

7. Verbindungsstruktur, umfassend:
einen Tragkörper (32),
ein Gehäuse (31), das ein Lüftungsloch (31h) aufweist und an dem Tragkörper befestigt ist, und
ein plattenförmiges Verbindungselement (1, 101, 201) nach einem der Ansprüche 1 bis 6, das zwischen dem Tragkörper und dem Gehäuse angeordnet ist, um so das Gehäuse an dem Tragkörper zu befestigen,
wobei die erste Klebeschicht (21) mit dem Gehäuse um das Lüftungsloch in Kontakt steht,
die erste Hauptfläche der luftdurchlässigen Membran (11) dem Lüftungsloch (31h) des Gehäuses zugewandt ist,
die zweite Klebeschicht (22) mit dem Tragkörper in Kontakt steht, und
die Lüftungsnut (1d, 101d, 201d) zwischen dem Tragkörper (32) und der luftdurchlässigen Membran (11) ausgebildet ist und mit dem äußeren Raum des Gehäuses (31) verbunden ist.

8. Verbindungsstruktur nach Anspruch 7, wobei
der Tragkörper (32) ein Solarzellenpanel ist und
das Gehäuse (31) ein Anschlusskasten einer Solarzelle ist.

## Revendications

1. Elément d'assemblage en forme de feuille ayant une fonction de ventilation et utilisé pour fixer un boîtier (31) ayant un trou d'évent (31h) sur un corps de support (32), l'élément d'assemblage comprenant :
une membrane perméable à l'air (11) ayant une première surface principale et une seconde surface principale ;
une première couche adhésive (21) prévue sur un côté de la première surface principale de la membrane perméable à l'air, la première couche adhésive étant adaptée pour être amenée en contact avec le boîtier (31) autour du trou d'évent (31h) ;
une ouverture (21h) formée dans la première couche adhésive de sorte que la première surface principale de la membrane perméable à l'air fait face au trou d'évent du boîtier lorsque la première couche adhésive vient en contact avec le boîtier ;
une deuxième couche adhésive (21, 122) prévue sur un côté de la seconde surface principale de la membrane perméable à l'air, la deuxième couche adhésive étant adaptée pour être en amenée en contact avec le corps de support ; et
une rainure d'évent (1d, 101d, 201d) formée à travers la deuxième couche adhésive (22, 122), ou bien entre la deuxième couche adhésive et la membrane perméable à l'air (11) afin de fournir un passage d'air entre le boîtier (31) et le corps de support (32) pour faire communiquer un intérieur du boîtier et un extérieur du boîtier lorsque le boîtier est fixé sur le corps de support à l'aide de l'élément d'assemblage, la rainure d'évent comprenant une première partie (D1) s'étendant à partir d'un bord périphérique externe de l'élément d'assemblage jusqu'à une région correspondant à l'ouverture (21h), et une seconde partie (D2) sur laquelle la seconde surface principale de la membrane perméable à l'air (11) est exposée dans la région correspondant à l'ouverture (21h),
dans lequel la rainure d'évent (1d, 101d, 201d) est formée entre le corps de support (32) et la membrane perméable à l'air (11) et communique avec l'espace extérieur du boîtier (31) lorsque le boîtier est fixé sur le corps de support à l'aide de l'élément d'assemblage.

2. Elément d'assemblage selon la revendication 1, comprenant en outre :
une entretoise (12) prévu entre la deuxième couche adhésive (22, 122) et la membrane perméable à l'air (11) ; et
une troisième couche adhésive (23) prévue entre l'entretoise (12) et la membrane perméable à l'air (11),
dans lequel la rainure d'évent (1d, 101d) est formée au moins à travers l'entretoise (12) de sorte que la rainure d'évent a une profondeur égale ou supérieure à une épaisseur de l'entretoise.

3. Elément d'assemblage selon la revendication 2, dans lequel :
la rainure d'évent (1d) est formée à travers la deuxième couche adhésive (22), l'entretoise (12) et la troisième couche adhésive de sorte que la rainure d'évent a une profondeur égale à une épaisseur totale de la deuxième couche adhésive (23), de l'entretoise et de la troisième couche adhésive, et
la rainure d'évent (1d) a un fond formé avec la seconde surface principale de la membrane perméable à l'air (11).

4. Elément d'assemblage selon la revendication 1, dans lequel :
la rainure d'évent (201d) est formée à travers la deuxième couche adhésive (22) de sorte que la rainure d'évent a une profondeur égale à une épaisseur de la deuxième couche adhésive, et
la rainure d'évent (201d) a un fond formé avec la seconde surface principale de la membrane perméable à l'air (11).

5. Elément d'assemblage selon la revendication 1, dans lequel la membrane perméable à l'air (11) comprend une membrane poreuse en polytétrafluoroéthylène.

6. Elément d'assemblage selon la revendication 1, dans lequel la première couche adhésive (21) et la deuxième couche adhésive (22, 122) sont chacune formées avec un ruban adhésif double face.

7. Structure d'assemblage comprenant :
un corps de support (32) ;
un boîtier (31) ayant un trou d'évent (31h) et fixé au corps de support ; et
un élément d'assemblage en forme de feuille (1, 101, 201) selon l'une quelconque des revendications 1 à 6, disposé entre le corps de support et le boîtier afin de fixer le boîtier sur le corps de support,
dans laquelle la première couche adhésive (21) est en contact avec le boîtier autour du trou d'évent ;
la première surface principale de la membrane perméable à l'air (11) fait face au trou d'évent (31h) du boîtier ;
la deuxième couche adhésive (22) est en contact avec le corps de support ; et
la rainure d'évent (1d, 101d, 201d) est formée entre le corps de support (32) et la membrane perméable à l'air (11) et communique avec l'espace extérieur du boîtier (31).

8. Structure d'assemblage selon la revendication 7, dans laquelle :
le corps de support (32) est un panneau solaire, et
le boîtier (31) est une boîte à bornes d'une cellule solaire.
